(19) Europäisches Patentamt
European Patent Office
Office européen des brevets

(11) **EP 2 867 685 B1**

(12) **FASCICULE DE BREVET EUROPEEN**

(45) Date de publication et mention de la délivrance du brevet:
**24.08.2016 Bulletin 2016/34**

(21) Numéro de dépôt: **13731827.5**

(22) Date de dépôt: **27.06.2013**

(51) Int Cl.:
*G01R 31/14* *(2006.01)*    *G01R 31/08* *(2006.01)*

(86) Numéro de dépôt international:
**PCT/EP2013/063547**

(87) Numéro de publication internationale:
**WO 2014/001466 (03.01.2014 Gazette 2014/01)**

(54) **DISPOSITIF ET PROCÉDÉ DE SURVEILLANCE D'UN RÉSEAU ÉLECTRIQUE**

VORRICHTUNG UND VERFAHREN ZUR ÜBERWACHUNG EINES ELEKTRISCHEN NETZWERKES

DEVICE AND METHOD FOR MONITORING AN ELECTRICAL NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.06.2012 FR 1256146**

(43) Date de publication de la demande:
**06.05.2015 Bulletin 2015/19**

(73) Titulaires:
• **Labinal Power Systems**
  **31700 Blagnac (FR)**
• **Klonowski, Thomas**
  **64160 Sedzere (FR)**

(72) Inventeurs:
• **KLONOWSKI, Thomas**
  **F-64160 Sedzere (FR)**
• **YBANEZ, Ludovic**
  **F-31470 Fontenilles (FR)**

(74) Mandataire: **Brevalex**
  **95, rue d'Amsterdam**
  **75378 Paris Cedex 8 (FR)**

(56) Documents cités:
**WO-A1-2009/005223    US-A1- 2009 161 272
US-A1- 2010 102 824**

• **MOMOH J A ET AL: "Design and analysis of aerospace DC arcing faults using fast fourier transformation and artificial neural network", 2003 IEEE POWER ENGINEERING SOCIETY GENERAL MEETING. CONFERENCE PROCEEDINGS. TORONTO, ONTARIO, CANADA, JULY, 13 - 17, 2003; [IEEE POWER ENGINEERING SOCIETY], NEW YORK, NY : IEEE, US, vol. 2, 1 janvier 2003 (2003-01-01), pages 788-793, XP010685982, DOI: 10.1109/PES.2003.1270407 ISBN: 978-0-7803-7989-3**

**Description**

**DOMAINE TECHNIQUE**

La présente invention concerne un procédé et un dispositif de surveillance d'un réseau électrique pour la détection de défauts ou prémices de panne dans un réseau électrique.

**ÉTAT DE LA TECHNIQUE ANTÉRIEURE**

Un réseau électrique permet d'acheminer l'énergie électrique à différentes charges électriques et comporte des moyens de protection conventionnels vis-à-vis de courts-circuits, de surintensités ou d'autres défaillances.

Les moyens de protection conventionnels permettent d'éviter la dégradation totale du réseau et sont efficaces quand les défauts sont énergétiques comme les courts-circuits, continus et progressifs comme les surcharges, ponctuels mais avec de fortes variations en courant et en tension, ou répétitifs dans le temps.

Or, les moyens conventionnels ne sont que très peu efficaces contre les défauts et leurs prémices de natures furtives, non stationnaires, et très peu énergétiques.

Toutefois, de part leur caractère difficilement détectable ces défauts qui appartiennent à la famille des décharges électriques (par exemple, prémices de l'amorçage d'arc électrique, impulsion de trichel, aigrettes, etc.) peuvent endommager le câblage du réseau électrique.

Les défauts dus à des décharges électriques sont en général bien connus mais sont encore à ce jour très mal détectés et leurs conséquences mal diagnostiquées.

Actuellement, il existe des techniques de détection consistant à mesurer des signaux électriques et à traiter ces signaux en temps et en fréquence. Cependant, ce genre de détection présente l'inconvénient de ne pas être très fiable et en particulier en cas de détection de prémices d'arcs ou d'arc tracking. De plus, cette technique de détection nécessite plusieurs confirmations, ce qui augmente le temps de détection et ne permet pas la localisation du défaut.

La demande US 2009/161272 A1 (25 juin 2009) décrit un dispositif de surveillance d'un réseau électrique comportant des moyens de détection des rayons ultraviolets et des signaux de radiofréquence pour analyser un événement de défaut dans le réseau électrique.

Il existe d'autres techniques de détection basées sur le principe de réflectométrie qui consiste à injecter une tension dans le réseau et à analyser la réflexion provoquée par un éventuel défaut afin de localiser ce défaut.

Cependant, l'injection d'une tension sur une ligne nécessite une maîtrise de l'impédance de la ligne, un couplage à la ligne, une distance au référentiel de masse à respecter, etc., entraînant une mise en oeuvre complexe. En outre, la réflectométrie n'est pas adaptée pour être utilisée dans certains types de réseaux.

Par ailleurs, les différentes techniques actuelles ne sont pas exhaustives sur la détection de défauts sur tout type de réseau qui peut être de nature alternatif, continu ou découpé.

L'objet de la présente invention est par conséquent de proposer un dispositif et un procédé de surveillance simple à mettre en oeuvre et qui est capable de détecter et de localiser rapidement et avec fiabilité les défauts dans un réseau électrique de nature quelconque sans injecter des signaux dans ledit réseau.

**EXPOSÉ DE L'INVENTION**

La présente invention est définie par un dispositif de surveillance d'un réseau électrique, comportant :

- des moyens de détection de signaux électriques et de signaux complémentaires produits dans le réseau électrique, les signaux complémentaires étant de nature physique différente des signaux électriques,

- des moyens de traitement desdits signaux électriques pour définir une première référence temporelle représentative d'un instant de détection des signaux électriques émis lors d'un événement de défaut survenu dans le réseau électrique,

- des moyens de traitement desdits signaux complémentaires pour définir une seconde référence temporelle représentative d'un instant de détection des signaux complémentaires émis lors dudit événement de défaut survenu dans le réseau électrique, et

- des moyens de traitement pour localiser spatialement ledit événement de défaut dans le réseau électrique en fonction desdites première et seconde références temporelles.

Ainsi, le dispositif selon l'invention met en oeuvre de manière simple, sans injection de signaux dans le réseau surveillé, une détection non intrusive des signaux électriques et complémentaire afin de réaliser une analyse globale du défaut en couplant les informations issues des signaux électriques créés par un défaut électrique (du type prémices d'arcs, arcs, arc tracking, et décharges partielles) avec celles issues des signaux complémentaires créés simultanément par le même défaut électrique. Ceci permet une détection fiable et une localisation spatiale assez précise du défaut dans le réseau (qui peut être de type alternatif, continu ou découpé) sans perturber le fonctionnement du réseau électrique.

Avantageusement, lesdits moyens de traitement sont configurés pour définir les première et seconde références temporelles en appliquant une analyse de traitement de signal sur lesdits signaux électriques et lesdits signaux complémentaires respectivement, ladite analyse de traitement étant choisie parmi les techniques de traitement suivantes : traitement par transformation en ondelettes, traitement de Fourier, et traitement de Wigner-Ville.

Toutes ces analyses ainsi que d'autres techniques de traitement peuvent être appliquées sur les signaux électriques et complémentaires. Plus particulièrement, l'analyse par transformation en ondelettes est très adaptée pour reconnaître de manière simple et précise la signature d'un défaut ayant un caractère furtif et/ou non linéaire tel qu'une décharge électrique.

Avantageusement, lesdits moyens de traitement sont configurés pour appliquer des analyses par transformation en ondelettes discrète.

La transformée discrète permet une reconstruction fiable du signal de manière rapide tout en évitant la redondance d'information lors de l'encodage permettant alors de minimiser l'espace de sauvegarde et la taille de mémoire.

Avantageusement, lesdits moyens de traitement sont configurés pour faire une cartographie identifiant la localisation des charges normales non linéaires dans ledit réseau électrique et pour discriminer un événement de défaut réel par rapport à un événement provoqué par une charge normale non linéaire identifiée dans ladite cartographie.

Ceci permet d'éviter le risque de couper le réseau de façon intempestive.

Avantageusement, lesdits moyens de traitement sont configurés pour déterminer des valeurs relatives à des facteurs quantitatifs du défaut, de comparer lesdites valeurs à des seuils critiques, et de déclencher une coupure immédiate lorsqu'une desdites valeurs dépasse le seuil critique.

Ceci permet de quantifier la criticité du défaut afin de maintenir la continuité de service du réseau électrique lorsque des prémices de défauts non critiques sont détectées tout en déterminant le moment où le défaut atteint un seuil de dangerosité nécessitant la coupure immédiate du circuit en défaut.

Avantageusement, lesdits moyens de traitement sont configurés pour enregistrer l'ensemble des événements de défauts.

Ceci permet d'évaluer la dégradation du réseau dans le temps.

Selon une particularité de la présente invention, les moyens de détection comportent des premiers moyens de détection desdits signaux électriques et des seconds moyens de détection desdits signaux complémentaires, lesdits premiers et seconds moyens de détection étant installés en un même endroit géographique en amont du réseau électrique.

Avantageusement, lesdits signaux complémentaires sont des signaux d'ondes mécaniques.

Ceci permet la détermination des coordonnées de l'événement de défaut avec une très grande précision. On notera que la précision de la localisation d'un défaut est directement proportionnelle à l'écart des vitesses de propagation des signaux électriques et mécaniques et que la propagation des ondes mécaniques est beaucoup plus faible que celle des signaux électriques.

L'invention vise également un système de réseau électrique dans un aéronef comportant un dispositif de surveillance selon l'une quelconque des caractéristiques précédentes. On notera que l'invention est applicable à tous les réseaux électriques (bâtiment, navire, ferroviaire, automobile, aéronef, etc.).

L'invention vise aussi un procédé de surveillance d'un réseau électrique, comportant les étapes suivantes :

- détection de signaux électriques et de signaux complémentaires produits dans le réseau électrique, les signaux complémentaires étant de nature physique différente des signaux électriques,

- traitement desdits signaux électriques pour définir une première référence temporelle représentative d'un instant de détection des signaux électriques émis lors d'un événement de défaut survenu dans le réseau électrique,

- traitement desdits signaux complémentaires pour définir une seconde référence temporelle représentative d'un instant de détection des signaux complémentaires émis lors dudit événement de défaut survenu dans le réseau électrique, et

- traitement pour localiser spatialement ledit événement de défaut dans le réseau électrique en fonction desdites première et seconde références temporelles.

**BRÈVE DESCRIPTION DES DESSINS**

D'autres caractéristiques et avantages de l'invention apparaîtront à la lecture de modes de réalisation préférentiels de l'invention faits en référence aux figures jointes parmi lesquelles :

La Fig. 1 illustre de manière schématique un dispositif de surveillance d'un réseau électrique, selon l'invention ;
Les Figs. 2A-2C illustrent les différentes étapes d'un processus d'analyse par ondelettes, selon l'invention ;
La Fig. 3 illustre de manière schématique un dispositif de surveillance d'un réseau électrique selon un mode de réalisation préféré de l'invention ;
La Fig. 4 est un logigramme par bloc illustrant le traitement des signaux par les moyens de traitement de la Fig. 3 selon une technique de transformée en ondelette discrète ;
Les Figs. 5A et 5B illustrent des exemples de filtres passe-bas et passe-haut utilisés dans le logigramme par bloc de la Fig. 4 ;
Les Figs. 6A-6C sont des graphiques illustrant la détection d'un événement de défaut sur des signaux électrique et mécanique, selon l'invention ; et
La Fig. 7 est un organigramme illustrant une analyse de l'évolution d'un défaut permettant de quantifier sa dangerosité, selon l'invention.

**EXPOSÉ DÉTAILLÉ DE MODES DE RÉALISATION PARTICULIERS**

Le concept à la base de l'invention repose sur le couplage de l'analyse des signaux électriques créés par un défaut électrique avec l'analyse de signaux complémentaires de natures différentes créés par le même défaut électrique.

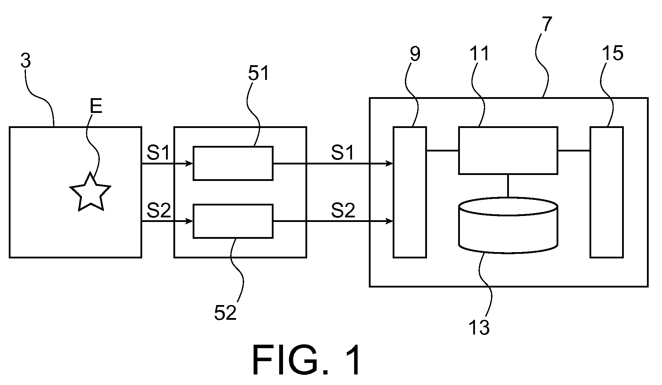

La Fig. 1 illustre de manière schématique un dispositif de surveillance 1 d'un réseau 3 électrique, selon l'invention. Ce dispositif comporte des moyens de détection 5 et des moyens de traitement 7 comprenant habituellement des moyens d'entrée 9, des moyens de calcul 11, des moyens de stockage 13, et des moyens de sortie 15. En particulier, les moyens de traitement 7 peuvent être utilisés pour exécuter un programme d'ordinateur enregistré dans les moyens de stockage 13 et comportant des instructions de code pour la mise en oeuvre du procédé de surveillance selon l'invention.

Les moyens de détection 5 sont configurés pour détecter de manière non intrusive, des signaux électriques S1 et des signaux complémentaires S2 produits dans le réseau électrique 3 et dont les vitesses de propagation sont connues. Les signaux complémentaires S2 sont de nature physique différente des signaux électriques S1 et peuvent être des ondes sonores, des ondes ultrasonores, des ondes de choc, des ondes lumineuses, des ondes radios, etc.

Plus particulièrement, les moyens de détection 5 comportent des premiers moyens de détection 51 pour détecter les signaux électriques S1 et des seconds moyens de détection 52 pour détecter les signaux complémentaires S2. Les premiers et seconds moyens de détection 51, 52 sont installés en un même endroit géographique en amont du réseau électrique 3.

Les moyens de traitement 7 sont configurés pour traiter et analyser les signaux électriques S1 et complémentaires S2 reçus via les moyens d'entrée 9 depuis les moyens de détection 5.

En premier lieu, les moyens de traitement 7 et plus particulièrement les moyens de calcul 11 sont configurés pour définir une première référence temporelle t1 représentative d'un instant de détection des signaux électriques S1 émis lors d'un événement de défaut E survenu dans le réseau électrique 3 ainsi qu'une seconde référence temporelle t2 représentative d'un instant de détection des signaux complémentaires S2 émis lors du même événement de défaut E.

En effet, les moyens de traitement 7 sont configurés pour appliquer une technique de traitement du signal temps-fréquence sur les signaux électriques S1 et sur les signaux complémentaires S2 afin de reconnaître la signature du défaut électrique E qui présente en général un caractère furtif et non linéaire. La technique de traitement du signal peut être une analyse de Fourier à court terme, une analyse par transformation (continue ou discrète) en ondelettes, ou une analyse par la méthode de Wigner-Ville.

L'analyse de Fourier à court terme est une analyse temps-fréquence du signal mesuré par segments qui permet de détecter les phénomènes non stationnaires. Toutefois, l'analyse de Fourier garde une fenêtre d'analyse fixe et convole le signal à analyser par des signaux test sinusoïdaux, et par conséquent, il y a un compromis à faire entre la détection de phénomènes basses fréquences et ceux de hautes fréquences.

L'analyse par transformation en ondelettes permet une localisation spatio-temporelle équilibrée qui ne privilégie pas un domaine de fréquence au détriment d'un autre, ceci par souci d'obtenir un équilibre entre la localisation temporelle et la localisation fréquentielle d'un signal.

Le principe de base de cette méthode est le fait de comprimer ou d'étirer les ondelettes afin qu'elles s'adaptent automatiquement aux différentes composantes du signal selon une analyse dite de multi-résolution. Cette analyse utilise une fenêtre étroite pour détecter les composantes transitoires de hautes fréquences et une fenêtre large pour détecter les composantes de basses fréquences (ou de longues durées).

De manière générale, la transformation en ondelettes consiste à créer, à partir d'une ondelette mère $\psi$, une

famille d'ondelettes (ou famille de fonctions) ψ(*ax* + *b*) qui sont des fonctions affines où *a* et *b* sont des nombres réels. Le facteur *a* (appelé échelle de dilatation) sert à dilater (*a*>1) ou à comprimer (*a*<1) la fonction et le terme *b* (appelé facteur de translation) sert à la translater.

La technique de transformation en ondelettes consiste à transformer un signal *f(t)* en une fonction *C(a,b)* à deux variables appelée «coefficient d'ondelette» de la manière suivante :

$$C(a,b) = \int\limits_{-\infty}^{+\infty} f(t) \times \psi(at+b)dt$$

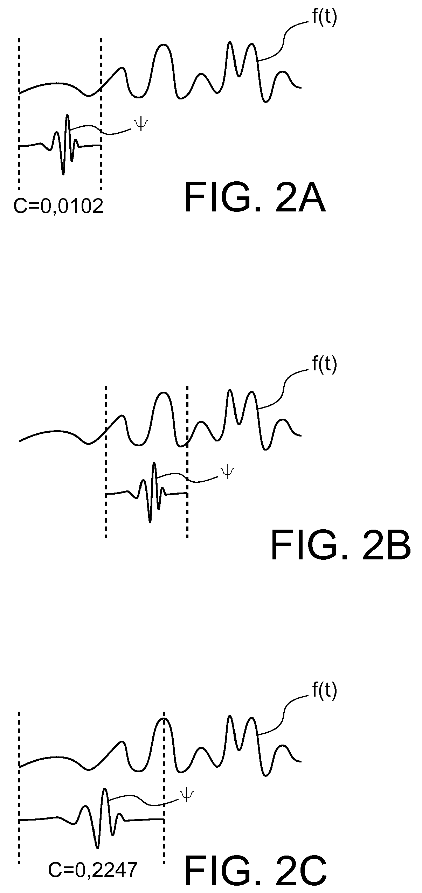

Les Figs. 2A-2C illustrent les différentes étapes du processus d'analyse par ondelettes.

La première étape (Fig. 2A) consiste à choisir une ondelette ψ et à la comparer à une partie du signal *f(t)* en commençant au même instant initial que le signal d'origine.

La deuxième étape (Fig. 2A) consiste à calculer un nombre C correspondant au coefficient d'ondelette. Plus ce coefficient est élevé plus il y a ressemblance entre l'intervalle du signal et l'ondelette. Le coefficient d'ondelette peut être interprété comme un coefficient de corrélation si le signal et l'ondelette sont d'énergie unitaire. Ainsi, plus ce coefficient tend vers 1 plus la probabilité de détecter l'événement d'un défaut sera élevée.

Selon l'exemple de la Fig. 2A, C=0,0102 mais bien entendu, la valeur du coefficient dépend aussi de la forme et des propriétés de l'ondelette que l'on choisit (orthogonale, biorthogonale, oblique, non orthogonal, support de l'ondelette, oscillation de l'ondelette, etc.).

La troisième étape (Fig. 2B) consiste à translater l'ondelette ψ vers la droite (c'est-à-dire, dans le sens du temps) puis on répète les première et deuxième étapes jusqu'à ce qu'elles couvrent la totalité du signal.

La quatrième étape (Fig. 2C) consiste à dilater ou à contracter (selon l'algorithme utilisé) l'ondelette, puis on répète les étapes précédentes.

La cinquième étape consiste à répéter les étapes précédentes pour chaque échelle de dilatation.

On notera que dans le cas d'une transformation continue, on peut translater et dilater l'ondelette, d'une façon indéfinie (dans la limite du pas d'échantillonnage des moyens informatiques de traitement), ce qui a pour conséquence l'empiétement des ondelettes l'une sur l'autre. L'avantage qui en ressort est que l'information encodée par une ondelette soit aussi encodée par ces voisines. Cela induit la notion de redondance d'information (en pratique la transformée continue est redondante par un facteur 10). Un autre avantage est l'invariance par translation et donc la non nécessité de préciser l'origine de l'encodage. Autrement dit, les coefficients ne changent pas si on déplace l'origine et il est donc plus facile d'analyser les données et de reconnaître les motifs.

En revanche, dans une transformation discrète, on ne translate et on ne dilate l'ondelette que selon des valeurs discrètes :

$$C(a,b) = \int\limits_{-\infty}^{+\infty} f(t) \times \Psi(at+b)dt \quad avec \quad a = 2^j, b = k2^j, (j,k) \in Z^2$$

Dans ce cas, les facteurs de dilatation *a* et de translation *b* sont basés sur une puissance de 2 donnant une représentation que l'on appelle dyadique. Cela signifie que les ondelettes fourniront une représentation avec beaucoup moins de redondance d'information que la transformation continue. La redondance d'information dépendra de la structure de l'ondelette que l'on choisit (orthogonale, biorthogonale, oblique, etc.).

L'avantage qui ressort d'une transformée discrète est la reconstruction parfaite du signal tout en évitant la redondance d'information lors de l'encodage. On aura donc un gain dans l'espace de sauvegarde et la taille de mémoire.

Dans le contexte de détection de signaux, il suffit d'identifier les coefficients d'ondelette sans le besoin de reconstruire le signal à partir de ces coefficients. On notera que pour la rapidité de traitement des signaux et l'optimisation de la taille des espaces de sauvegarde, il est plus avantageux d'effectuer une analyse discrète des signaux.

Ainsi, en appliquant par exemple la technique de traitement par transformation discrète en ondelettes, les moyens de traitement 7 déterminent les première et seconde références temporelles t1 et t2 correspondants respectivement aux instants de détection des signaux électriques et des signaux complémentaires émanant d'un événement de défaut E. En effet, les références temporelles t1 et t2 correspondent aux instants d'occurrences de coefficients d'ondelettes très élevés vis-à-vis des signaux électriques S1 et complémentaires S2.

En outre, les moyens de traitement 7 sont configurés pour localiser spatialement l'événement de défaut dans le réseau électrique 3 en fonction des première et seconde références temporelles t1 et t2.

En effet, en connaissant les vitesses de propagation des signaux électriques S1 et complémentaires S2 ainsi que l'écart de temps entre les instants de détection t1 et t2, on peut facilement déduire les coordonnées de l'événement de défaut E.

Avantageusement, les moyens de traitement 7 sont en outre configurés pour faire la cartographie du réseau électrique 3 afin d'identifier la localisation des charges normales non linéaires ayant des signatures similaires à celles des défauts, et d'enregistrer les données de la cartographie dans les moyens de stockage 13. Ceci permet aux moyens de traitement 7 de discriminer un événement de défaut E réel par rapport à un événement provoqué par une charge normale non linéaire identifiée dans la cartographie.

En outre, les moyens de traitement 7 sont configurés pour déterminer des valeurs relatives à des facteurs quantitatifs du défaut E qui peuvent être sa durée, son énergie, et son avancement sur le réseau 3. Ceci permet aux moyens de traitement 7 de quantifier la criticité du défaut en comparant chacune de ces valeurs à un seuil critique correspondant. Ainsi, les moyens de traitement 7 déclenchent via les moyens de sortie 15 une coupure immédiate du réseau 3 lorsqu'une de ces valeurs dépasse le seuil critique correspondant. En revanche, si les seuils critiques ne sont pas atteints, le défaut et ses caractéristiques sont gardés en mémoire dans les moyens de stockage 13 tout en maintenant le réseau 3 en service.

On notera que les moyens de traitement 7 sont configurés pour enregistrer en mémoire l'ensemble des événements de défauts et leurs caractéristiques afin d'évaluer la dégradation du réseau 3 dans le temps.

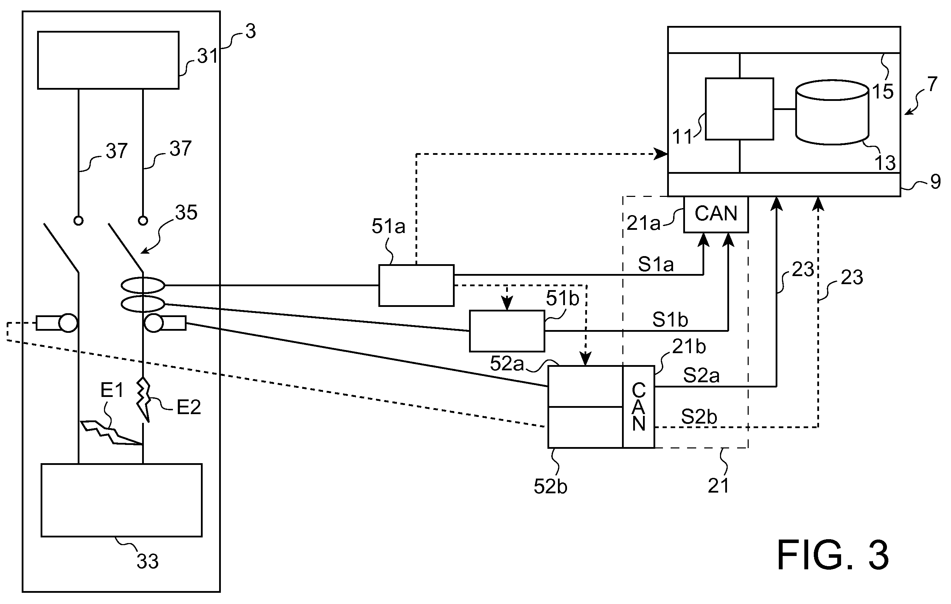

Sur la Fig. 3 est représenté un dispositif de surveillance d'un réseau électrique selon un mode de réalisation préféré de l'invention.

Le réseau électrique 3 comporte une alimentation électrique 31, des charges électriques 33, au moins un disjoncteur 35 de protection, et des câbles électriques 37.

Le dispositif de surveillance 1 est connecté au réseau électrique 3 et comporte des moyens de détection 5, et des moyens de traitement 7.

Comme précédemment, la surveillance est basée sur une double détection. La première détection concerne la détection du phénomène électrique par la mesure et l'analyse du courant S1a et de la tension S1b électrique de la ligne surveillée. La seconde détection concerne la détection des signaux complémentaires S2a du même phénomène afin de pouvoir confirmer sa détection et les localiser. Selon ce mode de réalisation, les signaux complémentaires S2a sont des signaux d'ondes (ou de vibration) mécaniques de type sonore ou ultrasonore qui ont une très bonne propagation dans le cuivre ou dans l'aluminium.

En effet, la création d'un arc électrique, et ceci est d'autant plus vrai sur des réseaux à fortes énergies, est source d'ondes acoustiques qui peuvent avoir des amplitudes très élevées. L'amplitude $|A|$ des ondes acoustiques d'un arc électrique est donnée par la formule suivante :

$$|A| = \frac{\partial W}{\partial t}$$

W étant l'énergie dissipée dans l'arc. On notera qu'un arc électrique peut créer à sa naissance un bruit atteignant 120 dBA.

Un arc électrique ou une décharge E1, E2 étant un phénomène très non linéaire à l'amorçage, la brusque variation de puissance provoquera la transmission de bruit d'amplitude sonore très brève et très élevée dans le conducteur d'un câble. La vitesse du son dans le cuivre étant de 3350 m/s à une température de 25°C, il est donc assez aisé de détecter le moment et l'endroit où aura lieu le défaut dans le réseau 3 électrique. Cette localisation sera d'autant plus précise que la détection se fera en couplant l'analyse des signaux électriques S1a, S1b et l'analyse des signaux sonores ou ultrasonores S2a.

Ainsi, les moyens de détection 5 comportent des premiers moyens de détection 51a, 51b des signaux électriques S1a, S1b et des seconds moyens de détection 52a des signaux d'ondes mécaniques S2a.

Plus particulièrement, les premiers moyens de détection 51a, 51b comportent des moyens de mesure de courant électrique 51a et des moyens de mesure de tension électrique 51b et les seconds moyens de détection comportent des moyens de mesure de vibration mécanique 52a. Les différents moyens de mesure 51a, 51b, et 52a sont installés en amont du réseau électrique 3 dans un même endroit géographique. Les moyens de mesure peuvent par exemple être intégrés dans un disjoncteur 35 de protection du réseau électrique 3.

Les moyens de mesure de courant 51a utilisent de manière connue une technologie (par exemple de type shunt de courant, tore de courant, etc.) adaptée à la nature du réseau électrique 3 qui peut être de type alternatif, continu ou découpé. La mesure du courant est réalisée en aval du disjoncteur 35 de protection et selon une bande passante qui peut aller jusqu'à quelques centaines de kHz.

Avantageusement, les moyens de détection 51a-52a et de traitement 7 du dispositif de surveillance peuvent être autoalimentés par les moyens de mesure de courant 51a en fonction du courant circulant dans la ligne 37.

Les moyens de mesure de tension 51b utilisent également une technologie adaptée à la nature du réseau électrique 3 avec une bande passante pouvant aller jusqu'à quelques centaines de kHz. Les moyens de mesure de tension 51b sont également installés en aval du disjoncteur 35 de protection et au plus près des moyens de mesure de courant 51a.

Les moyens de mesure de vibration mécanique 52a sont installés aussi au plus près géographiquement des moyens de mesures de tension 51b et de courant 51a et en aval du disjoncteur 35 de protection afin de localiser précisément l'endroit du défaut.

Les moyens de mesure de vibration mécanique 52a présentent une bande passante pouvant aller jusqu'à quelques centaines de kHz et peuvent comprendre des amplificateurs ainsi que des éléments de type microphonique, piézoélectrique, ou accélérométrique.

Avantageusement, la mesure de vibration mécanique est de préférence réalisée sur l'âme d'un conducteur car c'est à cet endroit que l'atténuation de la vibration est minimale en comparaison avec une mesure faite sur un isolant.

Selon un mode de réalisation particulier, les moyens de détection comportent des seconds moyens de mesure de vibration mécanique 52b placés sur le retour du courant spécifique à la ligne surveillée et au plus près du disjoncteur 35 de protection. Ceci permet d'augmenter la précision de la localisation spatiale de l'événement de défaut et de déterminer sa nature.

Pour un défaut de type parallèle E1, la signature de la vibration mécanique captée par les deux moyens de mesure de vibration mécanique 52a, 52b sera similaire. Toutefois, pour un défaut E2 de type série, la signature sera différente sur les deux moyens de mesure 52a, 52b car la vibration mécanique devra passer par la charge 33 pour un des deux moyens de mesure 52a, 52b. Dans ce cas, il faut prendre en compte des effets de distorsions, atténuations, et/ou retards d'acquisition sur les moyens de mesure les plus éloignés du défaut E2.

Par ailleurs, les moyens de traitement 7 comportent des moyens de calcul 11, des moyens de stockage 13, des moyens d'entrée 9 connectés à des convertisseurs analogiques/numériques « CAN » 21 interfaçant les différents moyens de mesure 51a-52b, et des moyens de sortie 15 connectés à des périphériques de sortie de type écrans, alarmes, disjoncteurs, et/ou imprimantes (non représentés).

On notera que lorsque la mesure de vibration mécanique est réalisée sur l'âme d'un conducteur, les moyens de mesure de vibration 52a, 52b sont galvaniquement isolés des moyens de traitement 7 par des fibres optiques 23, opto-coupleurs, transformateurs d'isolement etc. Dans ce cas, le CAN 21a connecté aux moyens de mesure de vibration 52a, 52b est installé du côté de ces derniers pour que l'isolement galvanique puisse être bien réalisé.

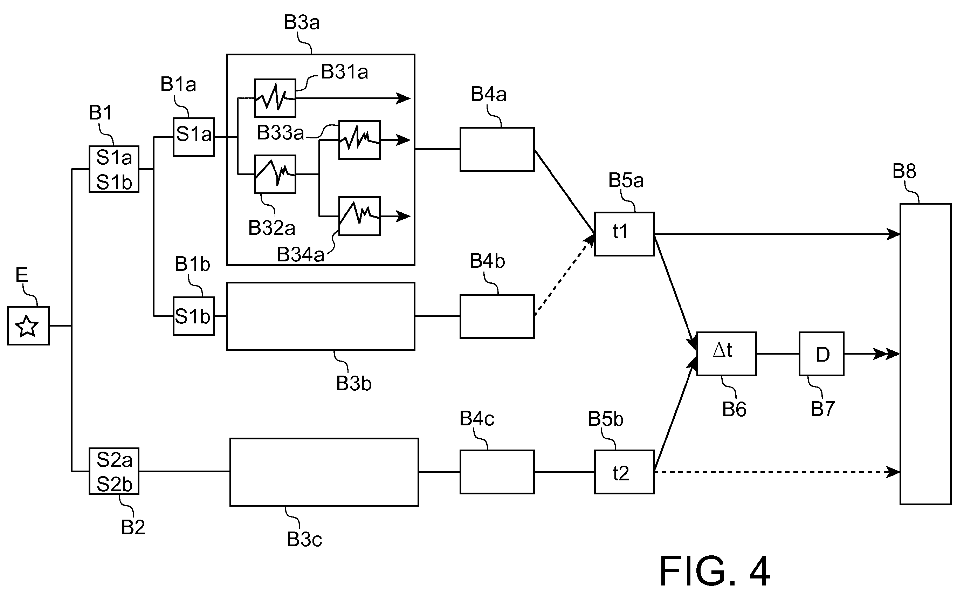

La Fig. 4 est un logigramme par bloc illustrant le traitement des signaux par les moyens de traitement de la Fig. 3 selon la technique de transformée en ondelette discrète.

Les moyens de traitement 7 sont configurés pour continuellement analyser par transformées en ondelettes discrètes les signaux électriques S1a, S1b et mécaniques S2a, S2b se propageant via le réseau électrique 3.

Le bloc B1 correspond à l'acquisition des signaux électriques S1a, S1b. Plus particulièrement, le bloc B1a concerne l'acquisition du courant électrique S1a et le bloc B1b concerne l'acquisition de la tension électrique S1b.

Le bloc B2 correspond à l'acquisition des signaux mécaniques S2a, S2b. On notera que pour des raisons de synchronismes dans l'analyse, l'acquisition des signaux électriques S1a, S1b et mécaniques S2a, S2b est fait avec la même base de temps et donc avec une même fréquence d'échantillonnage.

Les différents signaux de courant S1a, de tension S1b, et des ondes mécaniques S2a, S2b sont décomposés dans les blocs B3a, B3b, et B3c respectivement. Par souci de simplification, seul le bloc B3a est détaillé sachant que le principe de décomposition est le même pour les trois signaux.

On utilise par exemple la technique de multi-résolution connue pour l'homme du métier, et qui fournit un algorithme simple et rapide de décomposition d'un signal en ses composantes aux différentes échelles. A chaque étape on filtre avec un filtrage passe-bas (blocs B31a et B33a) pour obtenir les coefficients d'approximation et avec un passe-haut (blocs B32a et B34a) pour obtenir les coefficients de détail, puis on décime le résultat en sortie du filtre. Autrement dit, on prend un échantillon sur deux à la sortie de chaque filtre.

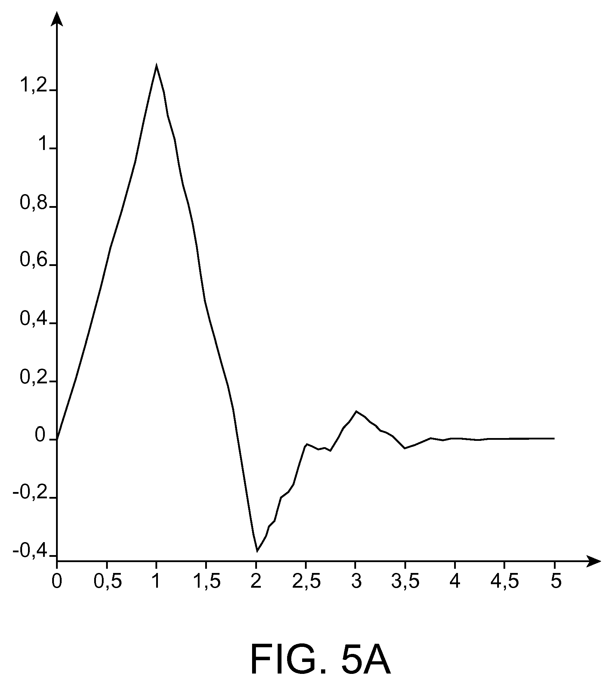

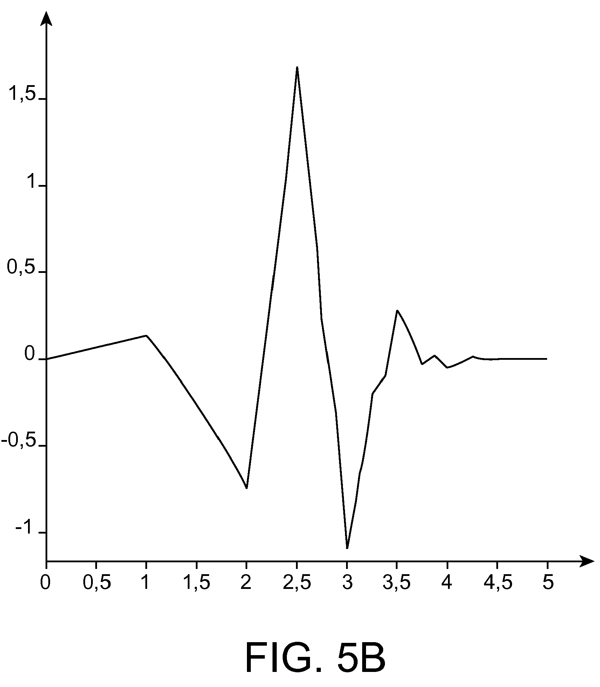

Le choix des filtres passe-haut et passe-bas dépend des signatures de signaux que l'on veut détecter. A titre d'exemple, le filtre passe-bas peut être associé à la fonction échelle (de type Daubechies 3) représentée sur la Fig. 5A qui donne une image grossière du signal tandis que le filtre passe-haut peut être associé à l'ondelette-mère (de type Daubechies 3) représentée sur la Fig. 5B qui encode les détails.

Ainsi, le signal de départ S1a est d'abord filtré avec des premiers filtres passe-bas (bloc B31a) et passe-haut (bloc B32a). Le signal à la sortie d'un des deux premiers filtres est gardé pour être analysé tandis que le signal à la sortie de l'autre filtre est filtré à nouveau avec des deuxièmes filtres passe-bas (bloc B33a) et passe-haut (bloc B34a). Ce processus est répété un nombre déterminé de fois pour décomposer le signal en une suite de composantes à des échelles différentes. Ces composantes sont ensuite analysées pour détecter l'occurrence des défauts.

En effet, en sortie des filtres, on obtient des coefficients d'ondelettes sur différentes échelles de fréquences. Ces coefficients peuvent être représentés sur un graphique de type scalogramme (blocs B4a et B4b). Selon l'algorithme de corrélation de la transformée en ondelette et en fonction du type d'ondelette, plus ce coefficient tendra vers 1 plus la probabilité de détecter l'occurrence d'un défaut sera élevée. Les coefficients très élevés sur les signaux électriques de tension et/ou de courant (bloc B4a) serviront de référence temporelle de l'existence du défaut définissant ainsi, l'instant t1 (bloc B5a). On notera que l'événement de défaut E est détecté simultanément sur les graphiques relatifs au courant et à la tension.

Au bloc B3c on peut utiliser également la technique de multi-résolution pour décomposer le signal des ondes mécaniques S2a ou S2b en ses composantes aux différentes échelles. De même, la présence de coefficients d'ondelette élevés sur un graphique de type scalogramme (blocs B4b) définira l'instant t2 (blocs B5b) sachant qu'un signal mécanique présente une propagation plus lente en direction des moyens de mesure.

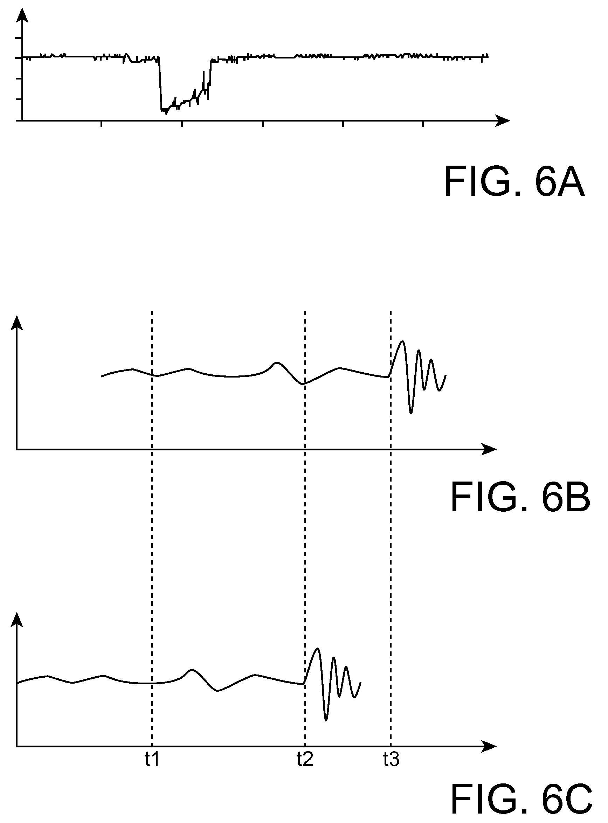

A titre d'exemple, les Figs. 6A-6C sont des graphiques illustrant la détection d'un événement de défaut E sur des signaux électrique S1a, S1b et mécanique S2a, S2b.

Plus particulièrement, la Fig. 6A illustre un signal électrique (courant S1a ou tension S1b) et les Figs. 6B et 6C illustrent des premier et second signaux mécaniques S2a, S2b (par exemple, signaux d'ondes sonores) relatifs à des premier et second moyens de détection mécaniques 52a, 52b (par exemple des premier et second micros).

En faisant une analyse par ondelette avec par exemple un logiciel de type Matlab, on obtient des scalogrammes (non représentés) sur lesquels on peut facilement identifier les coefficients d'ondelettes les plus élevées représentatives des occurrences des défauts. L'instant t1 indique le début de la détection du défaut sur le signal électrique S1 et l'instant t2 indique le début de la détection du même défaut sur le signal mécanique S2b d'un des moyens de détection mécaniques.

En outre, le retard de l'acquisition t3-t2 de la signature mécanique de l'événement du défaut entre les deux moyens de détection mécaniques 52a, 52b permet d'augmenter la précision de la localisation spatiale du défaut.

Au bloc B6, les moyens de calcul déterminent l'écart de temps Δt=t2-t1 entre l'arrivée des signaux électrique S1 et mécanique S2b. Cette durée Δt est utilisée à la prochaine étape pour en déduire à quelle distance des moyens de détection aura eu lieu le défaut.

En effet, au bloc B7 les moyens de calcul 11 déterminent la localisation spatiale du défaut E. La distance D du défaut par rapport aux moyens de détection 51a-52b peut être déterminée en fonction du retard Δt et des vitesses de propagation v1 et v2 des ondes électrique et mécanique à l'aide de la relation suivante :

$$D=\Delta t(v1v2)/(v1-v2).$$

On notera que la vitesse de propagation v2 de l'onde mécanique dans le cuivre ou dans d'autres métaux conducteurs est très lente (typiquement 3570m/s dans le cuivre) par rapport à la vitesse de propagation v1 des ondes électriques (typiquement 273000000m/s dans le cuivre). Ainsi, la distance D peut être calculée avec une grande précision par la simple multiplication de la vitesse de propagation v2 de l'onde mécanique par la durée du retard Δt. Le temps de détection de l'événement de défaut E dépend bien entendu de sa distance et de la vitesse de propagation de l'onde mécanique. Par exemple la détection d'un défaut E à 10m des moyens de détection 51a-52b devrait prendre moins de 3 ms.

Finalement, au bloc B8 les moyens de traitement 7 délivrent via les moyens de sortie 15, les coordonnées temporelles, fréquentielles et spatiales de l'événement de défaut E.

On notera que la méthode de détection selon l'invention est robuste et présente l'avantage de discriminer la signature des signaux de charges qui sont connectées sur le réseau 3 mais pouvant avoir un caractère non linéaire, et d'éviter ainsi le risque de couper le réseau 3 de façon intempestive et surtout sans raison.

En effet, dès le début de la mise en place du dispositif de surveillance 1 au plus près des outils de commande ou de protection (disjoncteur 35), celui-ci peut continuellement faire la cartographie du réseau électrique 3 qu'ils protègent et identifier l'endroit des charges ayant des signatures électrique et mécanique similaires aux prémices de défaut que l'on cherche à détecter.

Ainsi grâce au retard entre les signaux électriques S1 et mécaniques S2 tout au long de la durée de fonctionnement, le dispositif de surveillance 1 définit les zones comportant des charges non linéaires. Ceci permet au dispositif de surveillance 1 de distinguer un fonctionnement d'une charge normale non linéaire d'un événement de défaut par le fait que la charge provoque des signaux répétitifs et périodiques sans changement de position sur le réseau 3 et sans phénomènes mécaniques associés. Alors que le défaut engendre des signaux furtifs, apériodiques et variables en termes d'énergie et de localisation sur le réseau électrique 3 couplé avec des phénomènes mécaniques caractéristiques.

En outre, la méthode de détection selon l'invention permet pour des raisons de continuité de service de certains réseaux électriques, d'assurer un maintien maximal de ces derniers malgré des prémices de défaut pouvant exister pendant leur utilisation.

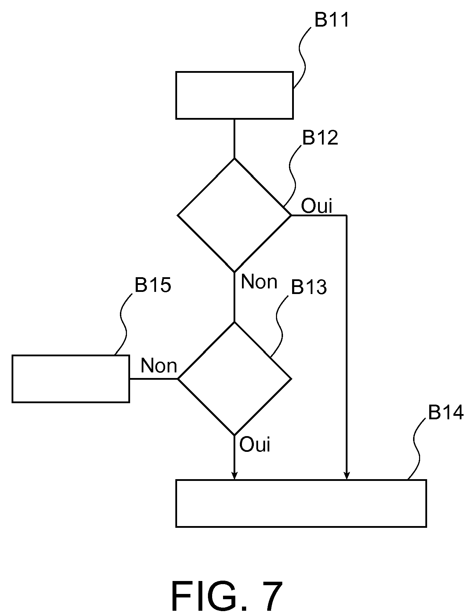

En effet, la Fig. 7 est un organigramme illustrant une analyse de l'évolution du défaut afin de quantifier la dangerosité de la présence du défaut.

Ceci peut être réalisé en corrélant plusieurs facteurs relatifs au défaut. Ces facteurs sont par exemple la durée de présence du défaut et l'énergie dissipée dans le défaut ainsi que l'évolution spatiale du défaut dans le réseau électrique.

Plus particulièrement, après la détection d'un défaut à l'étape B11, on passe aux tests des étapes B12 et B13.

A l'étape B12, on vérifie si la durée de défaut ou l'énergie dissipée dans le défaut dépasse un premier seuil prédéterminé. La durée de défaut et l'énergie dissipée peuvent être caractérisées par l'évolution de la densité des coefficients d'ondelettes élevés successifs. Si l'issue du test B12 est positif, on passe à l'étape B14 et sinon on passe à l'étape B13.

A l'étape B13, on vérifie si l'avancement du défaut sur le réseau dépasse un deuxième seuil prédéterminé. L'avancement du défaut ou l'évolution spatiale du défaut dans le réseau peut être caractérisé en analysant la réduction du retard entre la propagation des signaux électriques et la propagation des signaux mécaniques. Si l'issue du test B13 est positive, on passe à l'étape B14 et sinon on passe à l'étape B15.

On notera qu'on peut faire évoluer les premier et deuxième seuils prédéterminés en fonction des caractéristiques des dernières occurrences de défaut.

L'étape B14 indique que le seuil de dangerosité du défaut a été atteint et dans ce cas, les moyens de traitement 7 déclenchent la coupure du circuit en défaut.

A l'étape B15, les moyens de traitement 7 enregistrent les paramètres du défaut dans les moyens de stockage 13. On pourra donc relever par la suite ces paramètres pour prévoir un programme de maintenance approprié avant la défaillance du réseau.

Ainsi, selon cet algorithme si au moins une des deux conditions (définies dans les tests des étapes B12 et B13) est atteinte alors on considère que le défaut a atteint un seuil de dangerosité (étape B14) entraînant la coupure immédiate du circuit en défaut. Si aucune des conditions n'est atteinte, alors le défaut et ses caractéristiques seront gardés en mémoire (étape B15).

L'invention est applicable à tous les réseaux électriques dans les bâtiments, les navires, les automobiles, les aéronefs, ainsi que les réseaux ferroviaires.

On notera que le dispositif de surveillance est particulièrement adapté pour surveiller le câblage électrique dans un aéronef. Il permet d'analyser les signaux électriques et mécaniques dans le câblage de l'aéronef afin de déterminer l'écart de temps entre la détection des signaux électriques et mécaniques d'un événement de défaut, de déterminer la distance de l'anomalie, de déterminer les énergies mises en jeux dans les événements traités, et d'enregistrer l'ensemble des comportements afin d'évaluer la dégradation des câblages dans le temps.

On notera que le dispositif de surveillance 1 peut alors être intégré dans un boîtier spécifique ou faire partie d'un boîtier électronique existant dans l'aéronef. Avantageusement, on peut connecter les moyens de détection à des moyens d'acquisition et de traitement d'un calculateur embarqué, d'un disjoncteur electro-mécanique, ou tout autre équipement dans l'aéronef pour exploiter le procédé de surveillance selon l'invention.

## Revendications

**1.** Dispositif de surveillance d'un réseau électrique, **caractérisé en ce qu'**il comporte :

- des moyens de détection (51, 52) de signaux électriques (S1) et de signaux complémentaires (S2) produits dans le réseau (3) électrique, les signaux complémentaires (S2) étant de nature physique différente des signaux électriques (S1),
- des moyens de traitement (7) desdits signaux électriques pour définir une première référence temporelle (t1) représentative d'un instant de détection des signaux électriques émis lors d'un événement de défaut (E) survenu dans le réseau électrique,
- des moyens de traitement (7) desdits signaux complémentaires (S2) pour définir une seconde référence temporelle (t2) représentative d'un instant de détection des signaux complémentaires émis lors dudit événement de défaut survenu dans le réseau électrique, et
- des moyens de traitement pour localiser spatialement ledit événement de défaut dans le réseau électrique en fonction desdites première et seconde références temporelles (t1, t2).

**2.** Dispositif selon la revendication 1, **caractérisé en ce que** lesdits moyens de traitement sont configurés pour définir les première et seconde références temporelles en appliquant une analyse de traitement de signal sur lesdits signaux électriques et lesdits signaux complémentaires respectivement, ladite analyse de traitement étant choisie parmi les techniques de traitement suivantes : traitement par transformation en ondelettes, traitement de Fourier, et traitement de Wigner-Ville.

**3.** Dispositif selon la revendication 2, **caractérisé en ce que** lesdits moyens de traitement sont configurés pour appliquer une analyse par transformation en ondelettes discrète.

**4.** Dispositif selon l'une quelconque des revendications précédentes, **caractérisé en ce que** lesdits moyens de traitement sont configurés pour faire une cartographie identifiant la localisation des charges normales non linéaires dans ledit réseau électrique et pour discriminer un événement de défaut réel par rapport à un événement provoqué par une charge normale non linéaire identifiée dans ladite cartographie.

5. Dispositif selon l'une quelconque des revendications précédentes, **caractérisé en ce que** lesdits moyens de traitement sont configurés pour déterminer des valeurs relatives à des facteurs quantitatifs du défaut, de comparer lesdites valeurs à des seuils critiques, et de déclencher une coupure immédiate lorsqu'une desdites valeurs dépasse le seuil critique.

6. Dispositif selon l'une quelconque des revendications précédentes, **caractérisé en ce que** lesdits moyens de traitement sont configurés pour enregistrer l'ensemble des événements de défauts.

7. Dispositif selon l'une quelconque des revendications précédentes, **caractérisé en ce que** les moyens de détection comportent des premiers moyens de détection desdits signaux électriques et des seconds moyens de détection desdits signaux complémentaires, lesdits premiers et seconds moyens de détection étant installés en un même endroit géographique en amont du réseau électrique.

8. Dispositif selon l'une quelconque des revendications précédentes, **caractérisé en ce que** lesdits signaux complémentaires sont des signaux d'ondes mécaniques.

9. Système de réseau électrique dans un aéronef comportant un dispositif de surveillance selon l'une quelconque des revendications précédentes.

10. Procédé de surveillance d'un réseau électrique, **caractérisé en ce qu'**il comporte les étapes suivantes :

- détection (51, 52) de signaux électriques (S1) et de signaux complémentaires (S2) produits dans le réseau (3) électrique, les signaux complémentaires (S2) étant de nature physique différente des signaux électriques (S1),
- traitement (7) desdits signaux électriques pour définir une première référence temporelle (t1) représentative d'un instant de détection des signaux électriques émis lors d'un événement de défaut (E) survenu dans le réseau électrique,
- traitement (7) desdits signaux complémentaires (S2) pour définir une seconde référence temporelle (t2) représentative d'un instant de détection des signaux complémentaires émis lors dudit événement de défaut survenu dans le réseau électrique, et
- traitement pour localiser spatialement ledit événement de défaut dans le réseau électrique en fonction desdites première et seconde références temporelles (t1, t2).

## Patentansprüche

1. Vorrichtung zur Überwachung eines elektrischen Netzes, **dadurch gekennzeichnet, dass** sie umfasst:

- Mittel (51, 52) zur Erfassung von elektrischen Signalen (S1) und von komplementären Signalen (S2), die in dem elektrischen Netz (3) auftreten, wobei die komplementären Signale (S2) einen anderen physikalischen Ursprung haben als die elektrischen Signale (S1),
- Mittel (7) zur Verarbeitung der elektrischen Signale, um eine erste Zeitreferenz (t1) zu definieren, die repräsentativ ist für einen Erfassungszeitpunkt der elektrischen Signale, die während eines Fehlerereignisses (E) ausgesandt werden, das in dem elektrischen Netz auftritt,
- Mittel (7) zur Verarbeitung der komplementären Signale (S2), um eine zweite Zeitreferenz (t2) zu definieren, die repräsentativ ist für einen Erfassungszeitpunkt der komplementären Signale, die während des Fehlerereignisses ausgesandt werden, das in dem elektrischen Netz auftritt, und
- Verarbeitungsmittel zum räumlichen Lokalisieren des Fehlerereignisses in dem elektrischen Netz als Funktion der ersten und der zweiten Zeitreferenz (t1, t2).

2. Vorrichtung nach Anspruch 1, **dadurch gekennzeichnet, dass** die Verarbeitungsmittel dazu konfiguriert sind, die erste und die zweite Zeitreferenz durch Anwenden einer Signalverarbeitungsanalyse auf die elektrischen Signale beziehungsweise die komplementären Signale zu definieren, wobei die Verarbeitungsanalyse ausgewählt ist aus den folgenden Verarbeitungstechniken: Wavelet-Transformationsverarbeitung, Fourier-Verarbeitung, und Wigner-Ville-Verarbeitung.

3. Vorrichtung nach Anspruch 2, **dadurch gekennzeichnet, dass** die Verarbeitungsmittel dazu konfiguriert sind, eine Analyse durch diskrete Wavelet-Transformation anzuwenden.

4. Vorrichtung nach einem der vorhergehenden Ansprüche, **dadurch gekennzeichnet, dass** die Verarbeitungsmittel dazu konfiguriert sind, eine Kartographie durchzuführen, die die Lokalisierung der nicht linearen normalen Ladungen in dem elektrischen Netz identifiziert, und ein reelles Fehlerereignis von einem Ereignis zu unterscheiden, das durch eine in der Kartographie identifizierte nicht lineare normale Ladung provoziert ist.

5. Vorrichtung nach einem der vorhergehenden Ansprüche, **dadurch gekennzeichnet, dass** die Verarbeitungsmittel dazu konfiguriert sind, Werte bezüglich quantitativer Fehlerfaktoren zu bestimmen, die Werte mit kritischen Schwellen zu vergleichen, und eine sofortige Unterbrechung auszulösen, wenn einer der Werte die kritische Schwelle überschreitet.

6. Vorrichtung nach einem der vorhergehenden Ansprüche, **dadurch gekennzeichnet, dass** die Verarbeitungsmittel dazu konfiguriert sind, die Gesamtheit der Fehlerereignisse aufzuzeichnen.

7. Vorrichtung nach einem der vorhergehenden Ansprüche, **dadurch gekennzeichnet, dass** die Erfassungsmittel erste Erfassungsmittel für die elektrischen Signale und zweite Erfassungsmittel für die komplementären Signale umfassen, wobei die ersten und die zweiten Erfassungsmittel an ein und demselben geographischen Ort stromaufwärts des elektrischen Netzes installiert sind.

8. Vorrichtung nach einem der vorhergehenden Ansprüche, **dadurch gekennzeichnet, dass** die komplementären Signale mechanische Wellensignale sind.

9. Elektrisches Netzsystem in einem Luftfahrzeug, umfassend eine Vorrichtung zur Überwachung nach einem der vorhergehenden Ansprüche.

10. Verfahren zur Überwachung eines elektrischen Netzes, **dadurch gekennzeichnet, dass** es die folgenden Schritte umfasst:

- Erfassen (51, 52) von elektrischen Signalen (S1) und von komplementären Signalen (S2), die in dem elektrischen Netz (3) auftreten, wobei die komplementären Signale (S2) einen anderen physikalischen Ursprung haben als die elektrischen Signale (S1),
- Verarbeiten (7) der elektrischen Signale, um eine erste Zeitreferenz (t1) zu definieren, die repräsentativ ist für einen Erfassungszeitpunkt der elektrischen Signale, die während eines Fehlerereignisses (E) ausgesandt werden, das in dem elektrischen Netz auftritt,
- Verarbeiten (7) der komplementären Signale (S2), um eine zweite Zeitreferenz (t2) zu definieren, die repräsentativ ist für einen Erfassungszeitpunkt der komplementären Signale, die während des Fehlerereignisses ausgesandt werden, das in dem elektrischen Netz aufgetreten ist, und
- eine Verarbeitung zum räumlichen Lokalisieren des Fehlerereignisses in dem elektrischen Netz als Funktion der ersten und der zweiten Zeitreferenz (t1, t2).

**Claims**

1. Device for monitoring an electrical network, **characterised in that** it comprises:

- means (51, 52) for detecting electrical signals (S1) and additional signals (S2) produced in the electrical network (3), the additional signals (S2) being of a different physical nature to the electrical signals (S1),
- means (7) for processing said electrical signals to define a first time reference (t1) representing a detection time of the electrical signals emitted upon a fault event (E) arising in the electrical network,
- means (7) for processing said additional signals (S2) to define a second time reference (t2) representing a detection time of the additional signals emitted upon said fault event arising in the electrical network, and
- processing means for spatially locating said fault event in the electrical network according to said first and second time references (t1, t2).

2. Device according to claim 1, **characterised in that** said processing means are configured to define the first and second time references by applying a signal processing analysis on said electrical signals and said additional signals respectively, said processing analysis being chosen from the following processing techniques: wavelet transform processing, Fourier processing, and Wigner-Ville processing.

3. Device according to claim 2, **characterised in that** said processing means are configured to apply discrete wavelet transform analyses.

4. Device according to any of the above claims, **characterised in that** said processing means are configured to perform mapping identifying the location of the non-linear normal loads in said electrical network and to distinguish an actual fault event in relation to an event caused by a non-linear normal load identified in said mapping.

5. Device according to any of the above claims, **characterised in that** said processing means are configured to determine values relating to quantitative factors of the fault, compare said values to critical thresholds, and trigger an immediate cutoff when one of said values exceeds the critical threshold.

6. Device according to any of the above claims, **characterised in that** said processing means are configured to record all fault events.

7. Device according to any of the above claims, **characterised in that** the detection means comprise first means for detecting said electrical signals and second means for detecting said additional signals, said first and second detection means being installed at the same geographic location upstream from the electrical network.

8. Device according to any of the above claims, **characterised in that** said additional signals are mechanical wave signals.

9. Electrical network system in an aircraft comprising a monitoring device according to any of the above claims.

10. Method for monitoring an electrical network, **characterised in that** it comprises the following steps:

- detecting (51, 52) electrical signals (S1) and additional signals (S2) produced in the electrical network (3), the additional signals (S2) being of a different physical nature to the electrical signals (S1),
- processing (7) said electrical signals to define a first time reference (t1) representing a detection time of the electrical signals emitted on a fault event (E) arising in the electrical network,
- processing (7) said additional signals (S2) to define a second time reference (t2) representing a detection time of the additional signals emitted on said fault event arising in the electrical network, and
- processing for spatially locating said fault event in the electrical network according to said first and second time references (t1, t2).

FIG. 1

f(t)

ψ

C=0,0102

FIG. 2A

f(t)

ψ

FIG. 2B

f(t)

ψ

C=0,2247

FIG. 2C

FIG. 3

EP 2 867 685 B1

FIG. 4

FIG. 5A

FIG. 5B

FIG. 6A

FIG. 6B

FIG. 6C

FIG. 7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009161272 A1